# EUROPEAN PATENT SPECIFICATION

(11) **EP 2 458 649 B1**
(45) Date of publication and mention of the grant of the patent: **02.01.2019**
(21) Application number: 11008829.1
(22) Date of filing: 07.11.2011
(51) Int. Cl.: H01L 31/068, H01L 31/0224, H01L 31/18

(54) **Solar cell**
Solarzelle
Cellule solaire

(30) Priority: 11.11.2010 KR 20100111969
(43) Date of publication of application: 30.05.2012
(73) Proprietor: LG Electronics Inc., Seoul 150-721 (KR)
(72) Inventor: Lee, Daeyong, Seoul 137-724 (KR); Ahn, Junyong, Seoul 137-724 (KR); Ko, Jihoon, Seoul 137-724 (KR)
(74) Representative: Katérle, Axel

(56) References cited:
- WO-A1-2009/157079
- WO-A2-2008/115814
- WO-A2-2009/121604
- US-A1- 2009 223 549
- VYSOTSKII V N ET AL: "PHOTOVOLTAIC CELLS WITH ALUMINUM ALLOY CONTACTS AND A BASE PARTIALLY DOPED WITH LITHIUM", APPLIED SOLAR ENERGY (GELIOTEKHNIKA), ALLERTON PRESS INC, NEW YORK, US, vol. 27, no. 3, 1 January 1991 (1991-01-01), pages 16-19, XP000241686, ISSN: 0003-701X

## Description

### BACKGROUND OF THE INVENTION

### Field of the Invention

Embodiments of the invention relate to a solar cell.

### Description of the Related Art

Recently, as existing energy sources such as petroleum and coal are expected to be depleted, interests in alternative energy sources for replacing the existing energy sources are increasing. Among the alternative energy sources, solar cells have been particularly spotlighted because, as cells for generating electric energy from solar energy, the solar cells are able to draw energy from an abundant source and do not cause environmental pollution.

A solar cell generally includes a substrate and an emitter layer, each of which is formed of a semiconductor, and electrodes respectively formed on the substrate and the emitter layer. The semiconductors forming the substrate and the emitter layer have different conductive types, such as a p-type and an n-type. A p-n junction is formed at an interface between the substrate and the emitter layer.

When light is incident on the solar cell, a plurality of electron-hole pairs are generated in the semiconductors. The electron-hole pairs are separated into electrons and holes by the photovoltaic effect. Thus, the separated electrons move to the n-type semiconductor (e.g., the emitter layer) and the separated holes move to the p-type semiconductor (e.g., the substrate), and then the electrons and holes are collected by the electrodes electrically connected to the emitter layer and the substrate, respectively. The electrodes are connected to each other using electric wires to thereby obtain electric power.

Document WO 2009/121604 A2 discloses a solar cell comprising a back electrode layer positioned on the back passivation layer, electrically connected to the substrate through the at least one hole of the back passivation layer and formed using an Al paste heated to form an aluminum silicide. Document WO 2009/157079 A1 discloses a solar cell comprising a back electrode layer positioned on the back passivation layer, resulting from a firing step of an aluminum layer. Document WO 2008/115814 A2 discloses the use of an Al-Si alloy in a paste to form localized p+ contacts in holes formed in the back passivation layer of a solar cell as a possible alternative to an Al paste.

### SUMMARY OF THE INVENTION

In one aspect, there is a solar cell including a substrate of a first conductive type, an emitter layer positioned at an incident surface of the substrate, the emitter layer having a second conductive type opposite the first conductive type, a front electrode positioned on the incident surface of the substrate, the front electrode being electrically connected to the emitter layer, a back passivation layer positioned on a back surface opposite the incident surface of the substrate, the back passivation layer having at least one hole and containing intrinsic silicon, and a back electrode layer positioned on the back passivation layer, the back electrode layer being electrically connected to the substrate through the at least one hole of the back passivation layer, the back electrode layer containing a distribution of a silicon material.

The back electrode layer may contain the silicon material throughout an entire surface of the back electrode layer.

An amount of the silicon material contained in the back electrode layer may be about 6 wt% to 15 wt%.

The silicon material may be an alloy of silicon and aluminum.

Only a portion of the back electrode layer that includes a portion positioned inside the at least one hole of the back passivation layer may contain the silicon material.

The amount of the silicon material may increase in the back electrode in going from the back electrode layer towards the substrate. The amount of the silicon material may decrease in the back electrode layer in going away from the substrate.

The solar cell may further include a back surface field layer positioned at the back surface of the substrate electrically connected to the back electrode layer, the back surface field layer being more heavily doped with impurities of the first conductive type than the substrate.

The solar cell may further include an anti-reflection layer positioned on the emitter layer, the anti-reflection layer preventing a reflection of light incident from the outside.

Solar cells and method of manufacturing a solar cell according to the present invention are defined in claims 1, 2 and 9.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a partial perspective view of a solar cell according to an example embodiment of the invention;
FIG. 2 is a cross-sectional view taken along line II-II of FIG. 1;
FIG. 3 illustrates a void generated between a back electrode layer and a substrate in a process for manufacturing a solar cell according to an example embodiment of the invention;
FIGS. 4A to 4D illustrate graphs relating to effects of when a back electrode layer contains a silicon material according to an example embodiment of the invention;
FIG. 5 illustrates graphs relating to an optimum amount of silicon contained in a back electrode layer according to an example embodiment of the invention;
FIG. 6 illustrates an example embodiment of the invention where only a portion of a back electrode layer including a portion positioned inside a hole of a back passivation layer contains silicon material; and
FIGS. 7A to 7E illustrate stages in a method for manufacturing a solar cell according to an example embodiment of the invention.

### DETAILED DESCRIPTION OF THE EMBODIMENTS

The invention will be described more fully hereinafter with reference to the accompanying drawings, in which example embodiments of the inventions are shown. This invention may, however, be embodied in many different forms and should not be construed as limited to the embodiments set forth herein.

In the drawings, the thickness of layers, films, panels, regions, etc., are exaggerated for clarity. Wherever possible, the same reference numbers will be used throughout the drawings to refer to the same or like parts. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on another element, it may be on the entire surface of the other element and may not be on a portion of an edge of the other element.

Reference will now be made in detail to embodiments of the invention, examples of which are illustrated in the accompanying drawings.

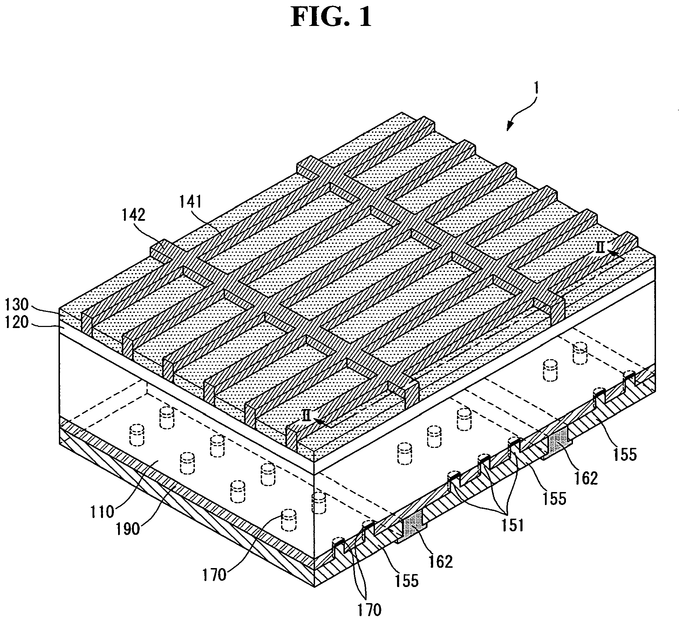

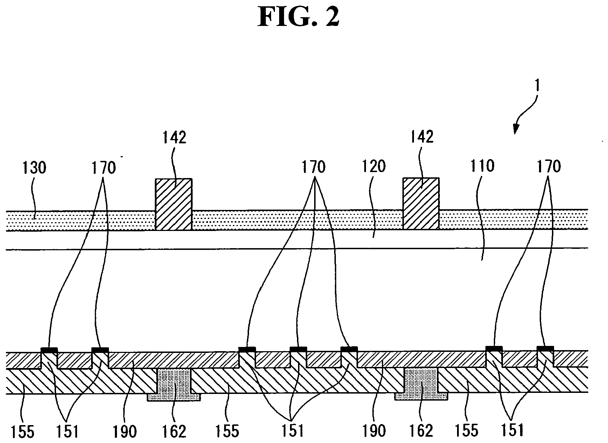

FIG. 1 is a partial perspective view of a solar cell according to an example embodiment of the invention. FIG. 2 is a cross-sectional view taken along line II-II of FIG. 1.

As shown in FIG. 1, a solar cell 1 according to an example embodiment of the invention includes a substrate 110, an emitter layer 120, an anti-reflection layer 130, a back passivation layer 190, front electrodes 141 and 142, a back electrode layer 155, a plurality of back bus bars 162, and a plurality of back surface field layers 170.

FIG. 1 illustrates the solar cell 1 according to the embodiment of the invention including the anti-reflection layer 130 and the plurality of back surface field layers 170. However, unlike the structure shown in FIG. 1, the anti-reflection layer 130 and the plurality of back surface field layers 170 may be omitted in other embodiments of the invention. However, it is preferable but not required that the solar cell 1 includes the anti-reflection layer 130 and the plurality of back surface field layers 170 in consideration of efficiency of the solar cell 1. Therefore, the embodiment of the invention describes the solar cell 1 including the anti-reflection layer 130 and the plurality of back surface field layers 170.

The substrate 110 is a semiconductor substrate formed of first conductive type silicon, for example, p-type silicon, though not required. Silicon used in the substrate 110 may be single crystal silicon, polycrystalline silicon, or amorphous silicon. When the substrate 110 is of a p-type, the substrate 110 may contain impurities of a group III element such as boron (B), gallium (Ga), and indium (In). Alternatively, the substrate 110 may be of an n-type. When the substrate 110 is of the n-type, the substrate 110 may contain impurities of a group V element such as phosphorus (P), arsenic (As), and antimony (Sb). Further, the substrate 110 may be formed of semiconductor materials other than silicon.

Unlike the structure illustrated in FIGS. 1 and 2, in an alternative embodiment, the surface of the substrate 110 may be textured to form a textured surface corresponding to an uneven surface or having uneven characteristics.

The emitter layer 120 is positioned at an incident surface (hereinafter, referred to as "a front surface") of the substrate 110 on which light is incident. The emitter layer 120 is a region doped with impurities of a second conductive type (for example, an n-type) opposite the first conductive type of the substrate 110. Thus, the emitter layer 120 of the second conductive type forms a p-n junction along with the substrate 110 of the first conductive type.

A plurality of electron-hole pairs produced by light incident on the substrate 110 are separated into electrons and holes by a built-in potential difference resulting from the p-n junction between the substrate 110 and the emitter layer 120. Then, the separated electrons move to the n-type semiconductor, and the separated holes move to the p-type semiconductor. Thus, when the substrate 110 is of the p-type semiconductor and the emitter layer 120 is of the n-type semiconductor, the separated holes move to the substrate 110 and the separated electrons move to the emitter layer 120. As a result, the holes become major carriers in the substrate 110, and the electrons become major carriers in the emitter layer 120.

Because the emitter layer 120 forms the p-n junction along with the substrate 110, the emitter layer 120 may be of the p-type when the substrate 110 is of the n-type unlike the embodiment described above. In this instance, the separated holes move to the emitter layer 120, and the separated electrons move to the substrate 110.

Returning to the embodiment of the invention when the emitter layer 120 is of the n-type, the emitter layer 120 may be formed by doping the substrate 110 with impurities of a group V element such as phosphorus (P), arsenic (As), and antimony (Sb). Alternatively, when the emitter layer 120 is of the p-type, the emitter layer 120 may be formed by doping the substrate 110 with impurities of a group III element such as boron (B), gallium (Ga), and indium (In).

The anti-reflection layer 130 is positioned on the emitter layer 120 and may be formed of silicon nitride (SiNx) and/or silicon oxide (SiO_{X}). The anti-reflection layer 130 reduces a reflectance of light incident on the solar cell 1 and increases selectivity of a predetermined wavelength band, thereby increasing the efficiency of the solar cell 1. The anti-reflection layer 130 may have a thickness of about 80 nm to 100 nm. The anti-reflection layer 130 may be omitted, if desired.

The front electrodes 141 and 142 are positioned on the emitter layer 120 and are electrically connected to the emitter layer 120. As shown in FIG. 1, the front electrodes 141 and 142 may include a plurality of finger electrodes 141 and a plurality of front bus bars 142.

The finger electrodes 141 are positioned on the emitter layer 120 and are electrically connected to the emitter layer 120. The finger electrodes 141 are spaced apart from one another at a predetermined distance and extend in a fixed direction. The finger electrodes 141 collect carriers (for example, electrons) moving to the emitter layer 120.

The front bus bars 142 are positioned on the emitter layer 120 at the same layer level as the finger electrodes 141. The front bus bars 142 are electrically connected to the finger electrodes 141 and extend in a direction crossing the finger electrodes 141. The front bus bars 142 collect the carriers (for example, electrons) collected by the finger electrodes 141 and output the carriers externally, for example, to an external device.

The finger electrodes 141 and the front bus bars 142 may be formed of at least one conductive material. Examples of the conductive material include at least one selected from the group consisting of nickel (Ni), copper (Cu), silver (Ag), aluminum (Al), tin (Sn), zinc (Zn), indium (In), titanium (Ti), gold (Au), and a combination thereof. Other conductive materials may be used.

As shown in FIGS. 1 and 2, the back passivation layer 190 is positioned on a back surface opposite the incident surface (i.e., the front surface) of the substrate 110. The back passivation layer 190 has at least one hole and may contain intrinsic silicon (i-Si).

The hole of the back passivation layer 190 may have a circular cross section shown in FIG. 1. Alternatively, the hole of the back passivation layer 190 may have a rectangular cross section, or cross sections of other shapes.

The back passivation layer 190 reduces a recombination of carriers around the back surface of the substrate 110 and improves an internal reflectance of light passing through the substrate 110, thereby increasing the reincidence of light passing through the substrate 110. The back passivation layer 190 may have a single-layered structure or a multi-layered structure. For example, the back passivation layer 190 may have a triple-layered structure. In this instance, the back passivation layer 190 may have the triple-layered structure sequentially including a silicon oxide (SiOx) layer, a silicon nitride (SiNx) layer, and a silicon oxynitride (SiOxNy) layer from the substrate 110. A thickness of the SiOx layer and a thickness of the SiOxNy layer may be greater than a thickness of the SiNx layer.

The back electrode layer 155 is positioned on the back passivation layer 190 and is electrically connected to the substrate 110 through the hole of the back passivation layer 190.

The back electrode layer 155 is positioned on the back passivation layer 190 excluding the back bus bars 162 from the back passivation layer 190. The back electrode layer 155 may be formed of a conductive material such as aluminum (Al). Alternatively, the back electrode layer 155 may be formed of at least one selected from the group consisting of nickel (Ni), copper (Cu), silver (Ag), tin (Sn), zinc (Zn), indium (In), titanium (Ti), gold (Au), and a combination thereof. Other conductive materials may be used.

The back electrode layer 155 includes a plurality of back electrodes 151 positioned inside the holes of the back passivation layer 190, so that the back electrode layer 155 is electrically connected to a portion of the substrate 110.

As shown in FIG. 1, the back electrodes 151 are spaced apart from one another at a distance of about 0.5 mm to 1 mm and may have various shapes such as a circular shape, an oval shape, and a polygon shape. The back electrodes 151 are electrically connected to the substrate 110 through the holes of the back passivation layer 190. However, unlike the structure illustrated in FIG. 1, each of the back electrodes 151 may extend in one direction while being electrically connected to the substrate 110. Namely, each back electrode 151 may have a stripe shape in the same manner as the finger electrode 141. In the instance, the number of back electrodes 151 having the stripe shape may be much less than the number of back electrodes 151 having the circular shape, the oval shape, or the polygon shape. The back electrodes 151 collect carriers (for example, holes) moving to the substrate 110 and transfer the carriers to the back electrode layer 155. The back electrodes 151 may be aligned and/or extended parallel to the finger electrodes 141.

The back electrode layer 155 may contain a silicon material. For example, the back electrode layer 155 may contain the silicon material throughout its entire surface.

The silicon material may be contained in the back electrode layer 155 by adding Si particles or Si beads formed of silicon material to a paste, for example, an Al paste forming the back electrode layer 155 and firing the Al paste containing the silicon material. Alternatively, the silicon material may be contained in the back electrode layer 155 by firing a Si-Al paste formed of an alloy of Si and Al to form the back electrode layer 155. When the back electrode layer 155 is formed using the Si-Al paste, the silicon material may be more uniformly distributed into the entire surface or volume of the back electrode layer 155. A distribution of the silicon material in the back electrode layer 155 may be uniform or homogenous, or may vary. For example, the distribution of the silicon material in the back electrode layer 155 may be constant regardless of depth or location of the back electrode layer 155, or may be localized and/or depend on the depth and/or location of the back electrode layer 155. Accordingly, the silicon material is an intentionally included in the back electrode layer or portions thereof.

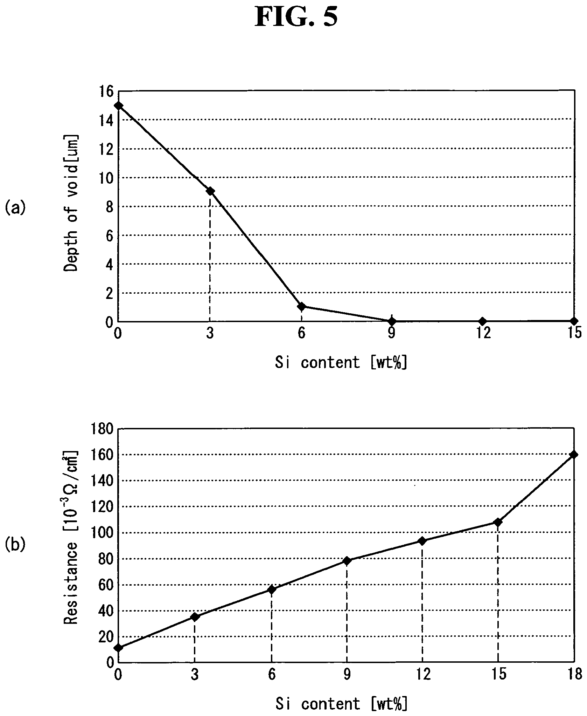

An amount of silicon material contained in the back electrode layer 155 may vary. This is described in detail with reference to FIG. 5.

When the back electrode layer contains the silicon material, a void may be prevented from being generated between the back electrode layer and the substrate in the firing process for forming the back electrode layer. Hence, a contact resistance between the back electrode layer and the substrate may be reduced, and an output voltage and a fill factor of the solar cell may increase. As a result, photoelectric efficiency of the solar cell may be improved.

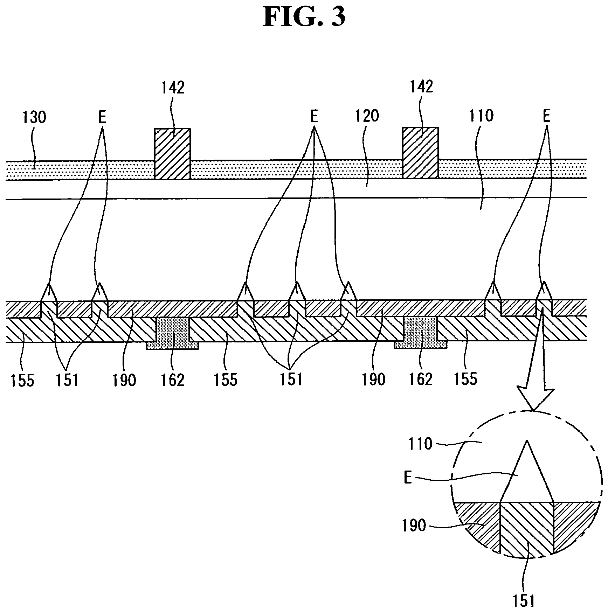

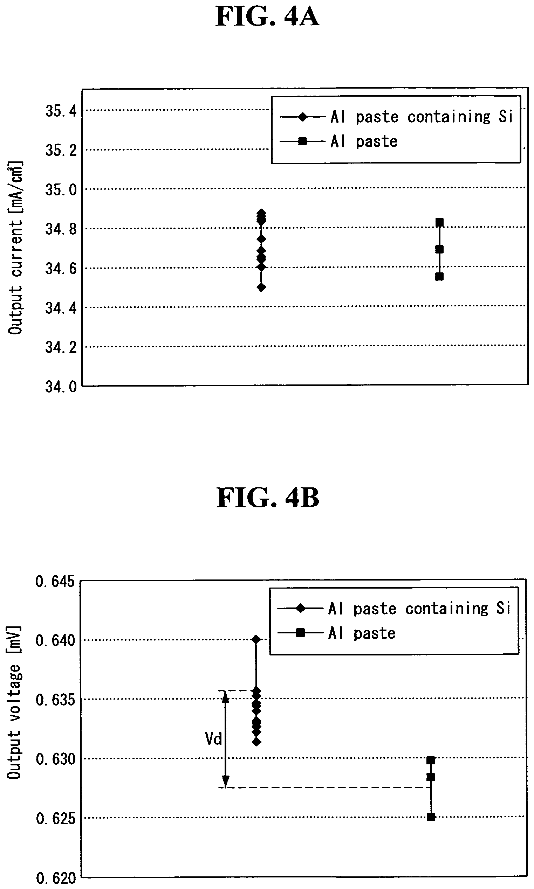

This is described in detail with reference to FIGS. 3 and 4A to 4D.

The plurality of back bus bars 162 are positioned on the back passivation layer 190 and are electrically connected to the back electrode layer 155. The back bus bars 162 may have a stripe shape extending in the same direction as the front bus bars 142. The back bus bars 162 may be positioned opposite the front bus bars 142 in an aligned or overlapping manner, but such is not required.

In the embodiment of the invention, the back bus bars 162 are positioned on the back passivation layer 190 so as not to overlap the back electrodes 151. Namely, as shown in FIGS. 1 and 2, the back bus bars 162 are positioned on the back passivation layer 190 in which the back electrodes 151 are not positioned. The location of the back bus bars 162 is not limited thereto.

Unlike the structure shown in FIGS. 1 and 2, the back bus bars 162 may include a plurality of electric conductors having a circular shape or a polygon shape, that are positioned to be spaced apart from one another at a constant distance.

The back bus bars 162 collect carriers (for example, holes) transferred from the back electrodes 151 through the back electrode layer 155 and output the carriers externally, for example, to the external device. Each of the back bus bars 162 has a width greater than a width of each of the back electrodes 151 and thus improves a transfer efficiency of carriers. As a result, operation efficiency of the solar cell 1 may be improved.

The back bus bars 162 may be formed of a conductive material such as silver (Ag). Alternatively, the back bus bars 162 may be formed of at least one selected from the group consisting of nickel (Ni), copper (Cu), aluminum (Al), tin (Sn), zinc (Zn), indium (In), titanium (Ti), gold (Au), and a combination thereof. Other conductive materials may be used.

The back bus bars 162 partially overlap the back electrode layer 155 adjacent to the back bus bars 162 and are electrically connected to the back electrode layer 155. In the embodiment of the invention, an overlap size between the back bus bar 162 and the back electrode layer 155 underlying the back bus bar 162 is about 0.1 mm to 1 mm. Thus, a contact resistance between the back bus bars 162 and the back electrode layer 155 is reduced, and contact efficiency therebetween is improved. As a result, the transfer efficiency of carriers from the back electrode layer 155 is improved.

In the embodiment of the invention, the back bus bars 162 contain silver (Ag) having better transfer efficiency than aluminum (Al) forming the back electrode layer 155, so as to increase the carrier transfer efficiency between the back bus bars 162 and the external device. When the overlap size between the back bus bar 162 and the back electrode layer 155 is greater than about 1 mm, an amount of silver used, that is more expensive than aluminum, increases. Hence, the manufacturing cost of the solar cell 1 may increase.

The back surface field layers 170 are positioned between the back electrodes 151 and the substrate 110. Each of the back surface field layers 170 is a region (for example, a p⁺-type region) more heavily doped with impurities of the same conductive type as the substrate 110 than the substrate 110.

The movement of carriers (for example, electrons) to the back surface of the substrate 110 is prevented or reduced by a potential barrier resulting from a difference between impurity concentrations of the substrate 110 and the back surface field layers 170. Thus, a recombination and/or a disappearance of electrons and holes around the back surface of the substrate 110 are prevented or reduced.

An operation of the solar cell 1 according to the embodiment of the invention, in which the back passivation layer 190 is formed on the back surface of the substrate 110 to thereby prevent or reduce the recombination and/or the disappearance of carriers resulting from unstable bonds existing in the surface of the substrate 110, is described below.

When light irradiated onto the solar cell 1 is incident on the substrate 110 through the anti-reflection layer 130 and the emitter layer 120, a plurality of electron-hole pairs are generated in the substrate 110 by light energy based on the incident light. In this instance, because a reflection loss of the light incident on the substrate 110 is reduced by the anti-reflection layer 130, an amount of light incident on the substrate 110 increases.

The electron-hole pairs are separated into electrons and holes by the p-n junction of the substrate 110 and the emitter layer 120, and the separated electrons move to the n-type emitter layer 120 and the separated holes move to the p-type substrate 110. The electrons moving to the n-type emitter layer 120 are collected by the finger electrodes 141 and then are transferred to the front bus bars 142. The holes moving to the p-type substrate 110 are transferred to the back electrodes 151 and then are collected by the back bus bars 162. When the front bus bars 142 are connected to the back bus bars 162 using electric wires, current flows therein to thereby enable use of the current for electric power.

Because the back protection layer 190 is positioned between the substrate 110 and the back electrode layer 155, the back protection layer 190 prevents or reduces the recombination and/or the disappearance of carriers resulting from unstable bonds existing at the surface of the substrate 110. Hence, the efficiency of the solar cell 1 is improved.

FIG. 3 illustrates a void generated between the back electrode layer 155 and the substrate 110 in the process for manufacturing the solar cell 1.

In the process for manufacturing the solar cell 1, the back protection layer 190 is deposited and formed on the back surface of the substrate 110. Then, a portion of the back protection layer 190 to form a local contact is patterned using a method such as a laser or an etching paste, so as to form the local contact between the back electrode layer 155 and the substrate 110. Hence, the holes of the back protection layer 190 are formed. Subsequently, a paste (for example, Al paste) forming the back electrode layer 155 is printed on the back protection layer 190 through a screen printing method.

Next, a thermal process is performed on the paste forming the back electrode layer 155 at a high temperature, for example, of about 800 °C to fire the paste forming the back electrode layer 155.

As shown in FIG. 3, a void (or voids) E may be generated between the back electrode layer 155 and the substrate 110 in the thermal process for firing the paste forming the back electrode layer 155.

A reason why the void E is generated between the back electrode layer 155 and the substrate 110 is because solubility of silicon of the substrate 110 contained in the Al paste forming the back electrode layer 155 increases in the thermal process performed at the high temperature. Thus, silicon from the substrate 110 enters into the Al paste during the formation of the back electrode layer 155.

Accordingly, Si particles or Si beads formed of silicon material are previously added to the Al paste forming the back electrode layer 155, so as to prevent silicon of the substrate 110 from entering into the Al paste. Hence, when the Al paste including the Si particles or the Si beads is fired, the silicon material of the substrate 110 may be prevented from entering into the Al paste forming the back electrode layer 155. That is, Si particles or Si beads formed of silicon material are intentionally added to the Al paste prior to forming of the back electrode layer 155.

As above, when the Si particles or the Si beads are added to the back electrode layer 155, an output voltage and a fill factor of the solar cell 1 increase. As a result, the photoelectric efficiency of the solar cell 1 may be improved.

FIGS. 4A to 4D illustrate an effect when the back electrode layer 155 contains the silicon material.

More specifically, FIGS. 4A to 4D are graphs illustrating the result of a comparison between an example where the back electrode layer 155 contains only aluminum and an example where the back electrode layer 155 contains both aluminum and the silicon material. In FIGS. 4A to 4D, about 6 wt% of silicon was added to aluminum.

As shown in FIG. 4A, when the back electrode layer 155 contained only aluminum, an output current was about 34.55 mA/cm² to 34.82 mA/cm². When the back electrode layer 155 contained both aluminum and the silicon material, the output current was about 34.50 mA/cm² to 34.90 mA/cm².

As above, the output current was little affected by silicon contained in the back electrode layer 155. In other words, output current is not detrimentally affected by the silicon material contained in the back electrode layer 155.

As shown in FIG. 4B, when the back electrode layer 155 contained only aluminum, an output voltage was about 0.625 mV to 0.630 mV. When the back electrode layer 155 contained both aluminum and the silicon material, the output voltage was about 0.631 mV to 0.640 mV.

Accordingly, a difference of about 0.001 mv to 0.01 mV in the output voltage was generated depending on whether or not the back electrode layer 155 contained silicon. The difference of about 0.007 mV in the output voltage was generated as a middle value.

In other words, the output voltage further increased when the back electrode layer 155 contained silicon.

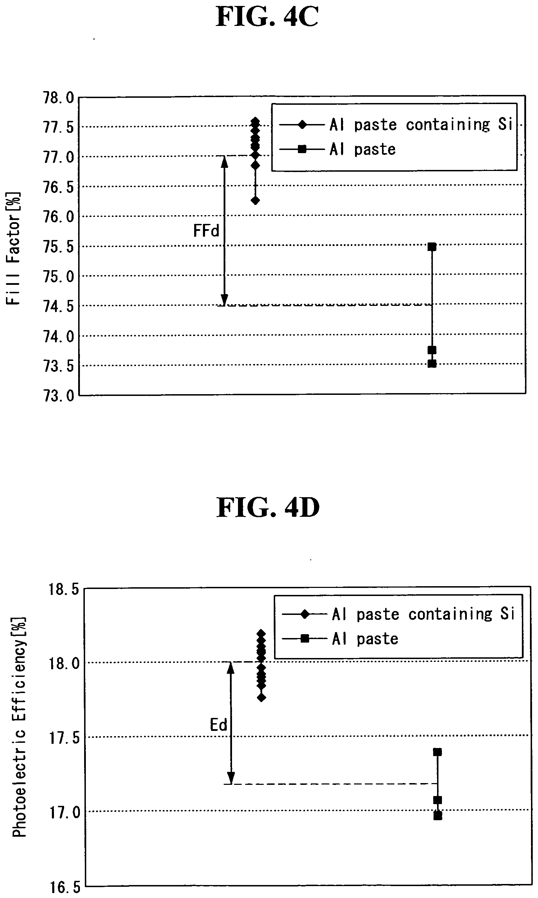

As shown in FIG. 4C, when the back electrode layer 155 contained only aluminum, a fill factor was about 73.5 % to 75.5 %. When the back electrode layer 155 contained both aluminum and the silicon material, the fill factor was about 76.3 % to 77.7 %.

Accordingly, a difference of about 0.8 % to 4.2 % in the fill factor was generated depending on whether or not the back electrode layer 155 contained silicon. The difference of about 2.5 % in the fill factor was generated as a middle value.

In other words, the fill factor further increased when the back electrode layer 155 contained silicon.

As shown in FIG. 4D, the photoelectric efficiency of the solar cell was further improved when the back electrode layer 155 contained silicon.

More specifically, when the back electrode layer 155 contained only aluminum, the photoelectric efficiency of the solar cell was about 17.0 % to 17.4 %. When the back electrode layer 155 contained both aluminum and the silicon material, the photoelectric efficiency of the solar cell was about 17.8 % to 18.3 %.

Accordingly, a difference of about 0.4 % to 1.3 % in the photoelectric efficiency of the solar cell was generated depending on whether or not the back electrode layer 155 contained silicon. The difference of about 0.7 % in the photoelectric efficiency of the solar cell was generated as a middle value.

In other words, the photoelectric efficiency greatly increased when the back electrode layer 155 contained silicon.

FIGS. 4A to 4D illustrate results obtained when about 6 wt% of silicon was contained in the back electrode layer 155. The amount of silicon contained in the back electrode layer 155 may vary. For example, silicon of more than 6 wt% may be contained in the back electrode layer 155. An optimum amount of silicon contained in the back electrode layer 155 is described below.

FIG. 5 illustrates an optimum amount (unit: wt%) of silicon contained in the back electrode layer.

In FIG. 5,(a) is a graph illustrating a depth of a void E generated between the back electrode layer 155 and the substrate 110 depending on an amount of silicon contained in the back electrode layer 155; and (b) is a graph illustrating a resistance per unit area of the back electrode layer 155 depending on an amount of silicon contained in the back electrode layer 155.

As shown in (a) of FIG. 5, when the back electrode layer 155 did not contain silicon, the depth of the void E was about 15 µm; when the back electrode layer 155 contained about 3 wt% of silicon, the depth of the void E was about 9 µm; when the back electrode layer 155 contained about 6 wt% of silicon, the depth of the void E was about 1 µm; and when the amount of silicon contained in the back electrode layer 155 was more than about 9 wt%, the void E was little generated between the back electrode layer 155 and the substrate 110.

As indicated by the graph (a) of FIG. 5, when the amount of silicon increased to about 6 wt%, the depth of the void E was greatly reduced. On the other hand, a reduction width in the depth of the void E when the amount of silicon was more than about 6 wt% was less than a reduction width in the depth of the void E when the amount of silicon was equal to or less than about 6 wt%.

As shown in (b) of FIG. 5, when the back electrode layer 155 did not contain silicon, the resistance per unit area of the back electrode layer 155 was about 10×10⁻³ Ω/m²; when the amount of silicon contained in the back electrode layer 155 was about 3 wt%, the resistance per unit area of the back electrode layer 155 was about 35×10⁻³ Ω/m²; when the amount of silicon was about 6 wt%, the resistance per unit area of the back electrode layer 155 was about 58×10⁻³ Ω/m²; when the amount of silicon was about 9 wt%, the resistance per unit area of the back electrode layer 155 was about 79×10⁻³ Ω/m²; when the amount of silicon was about 12 wt%, the resistance per unit area of the back electrode layer 155 was about 92×10⁻³ Ω/m²; when the amount of silicon was about 15 wt%, the resistance per unit area of the back electrode layer 155 was about 108×10⁻³ Ω/m²; and when the amount of silicon was about 18 wt%, the resistance per unit area of the back electrode layer 155 was about 160×10⁻³ Ω/m².

As indicated by the graph (b) of FIG. 5, when the amount of silicon contained in the back electrode layer 155 was equal to or less about 15 wt%, the resistance per unit area of the back electrode layer 155 slowly increased. On the other hand, an increase width (or a rate of increase) in the resistance per unit area of the back electrode layer 155 when the amount of silicon was more than about 15 wt% was greater than an increase width (or a rate of increase) in the resistance per unit area of the back electrode layer 155 when the amount of silicon was equal to or less than about 15 wt%.

As above, the amount of silicon contained in the back electrode layer 155 may be about 6 wt% to 15 wt% in consideration of the depth of the void E and the resistance of the back electrode layer 155. Namely, the minimum amount of silicon may be set to about 6 wt% capable of greatly reducing the depth of the void E, and the maximum amount of silicon may be set to about 15 wt% not greatly increasing the resistance of the back electrode layer 155.

Accordingly, when the amount of silicon contained in the back electrode layer 155 is equal to or more about 6 wt%, the depth of the void E may be minimized. Further, when the amount of silicon contained in the back electrode layer 155 is equal to or less about 15 wt%, the resistance of the back electrode layer 155 may be minimized.

An example method for manufacturing the solar cell 1 shown in FIGS. 1 and 2 is described below.

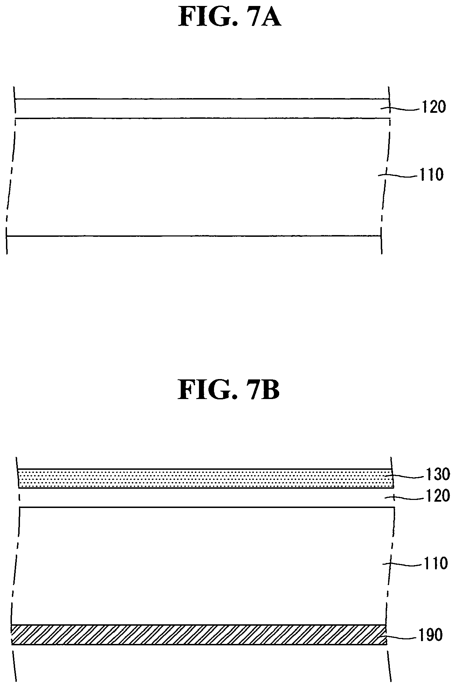

FIGS. 7A to 7E illustrate a method for manufacturing the solar cell according to the embodiment of the invention.

As shown in FIG. 7A, impurities of a second conductive type, for example, n-type are distributed into the substrate 110 of a first conductive type, for example, p-type to form the emitter layer 120 at the surface of the substrate 110. When the emitter layer 120 is formed at the surface of the substrate 110, the emitter layer 120 may be formed at both the front and back surfaces of the substrate 110. The emitter layer 120 formed at the back surface of the substrate 110 may be removed after an impurity distribution process is performed.

As shown in FIG. 7B, after the emitter layer 120 is formed at the front surface of the substrate 110, the anti-reflection layer 130 is formed on the front surface of the substrate 110. Further, the back passivation layer 190 is formed on the back surface of the substrate 110 using a plasma enhanced chemical vapor deposition (PECVD) method.

The anti-reflection layer 130 and the back passivation layer 190 may be formed using at least one of silicon oxide (SiOx), silicon nitride (SiNx), and silicon oxynitride (SiOxNy). The anti-reflection layer 130 and the back passivation layer 190 may have the multi-layered structure including at least two layers each having a different refractive index. When the anti-reflection layer 130 and the back passivation layer 190 include at least two layers each having the different refractive index, an anti-reflection effect of the anti-reflection layer 130 and a passivation function of the back passivation layer 190 may be further improved.

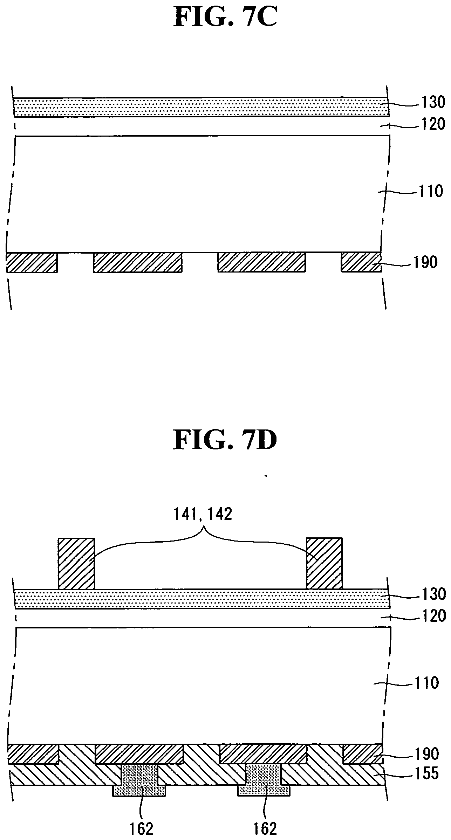

As shown in FIG. 7C, after the anti-reflection layer 130 and the back passivation layer 190 are respectively formed on the front surface and the back surface of the substrate 110, at least one hole is formed in the back passivation layer 190. The hole of the back passivation layer 190 may be formed using a laser etching equipment, for example, a laser ablation device.

Next, as shown in FIG. 7D, a front electrode paste containing silver, etc., is printed on the anti-reflection layer 130 using a mask for forming the front electrodes 141 and 142 to form a pattern of the finger electrode 141 and a pattern of the front bus bar 142. A back bus bar paste containing silver, etc., is formed on the back passivation layer 190 using a mask forming the back bus bar 162 to form a pattern of the back bus bar 162. Further, the Al paste containing the silicon material passes through the hole of the back passivation layer 190 using a mask and is screen-printed to form a pattern of the back electrode layer 155 connected to the substrate 110.

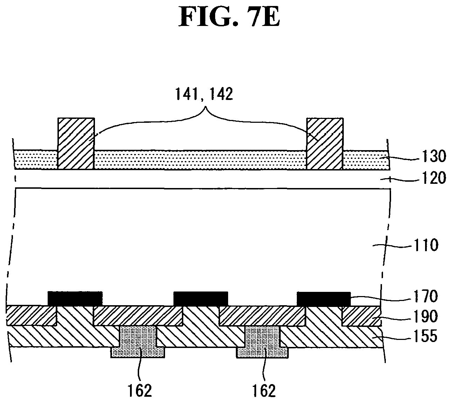

Next, as shown in FIG. 7E, the pattern of the finger electrode 141, the pattern of the front bus bar 142, the pattern of the back bus bar 162, and the pattern of the back electrode layer 155 are simultaneously fired. Hence, the finger electrode 141 and the front bus bar 142 pass through the anti-reflection layer 130 and are electrically connected to the emitter layer 120. At the same time, the back electrode layer 155 is formed using the Al paste containing the silicon material without forming or generating the void between the back electrode layer 155 and the substrate 110. Further, the back surface field layer 170 is formed between the substrate 110 and the back electrode layer 155.

In the method for manufacturing the solar cell according to the embodiment of the invention, because the back electrode layer 155 is formed using the Al paste containing the silicon material, the void may be prevented or reduced from being generated between the back electrode layer 155 and the substrate 110 after the firing process of the back electrode layer 155.

So far, the embodiment of the invention described the back electrode layer 155 as containing the silicon material throughout its entire surface. However, in other embodiments of the invention, only a portion of the back electrode layer 155 positioned inside the hole of the back passivation layer 190, i.e., only a portion of the back electrode layer 155 including the back electrode 151 may contain the silicon material.

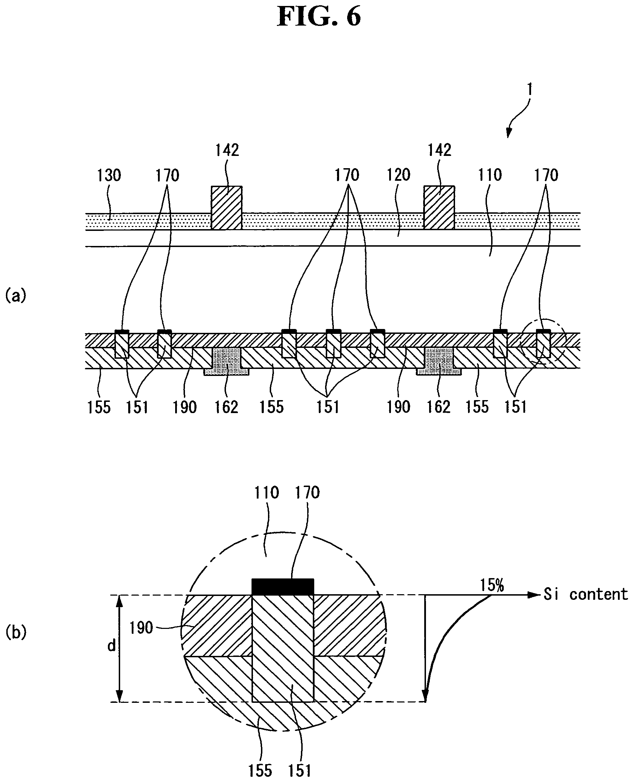

FIG. 6 illustrates an example where only a portion of the back electrode layer including a portion positioned inside the hole of the back passivation layer contains the silicon material.

As shown in FIG. 6, only a portion of the back electrode layer 155 positioned inside the hole of the back passivation layer 190, i.e., only a portion of the back electrode layer 155 including the back electrode 151 may contain the silicon material.

As shown in (a) of FIG. 6, when only the portion of the back electrode layer 155 including the back electrode 151 positioned inside the hole of the back passivation layer 190 contains the silicon material, the silicon material may be uniformly distributed into the entire surface of the back electrode 151.

As shown in (a) of FIG. 6, when only the portion of the back electrode layer 155 including the back electrode 151 contains the silicon material, the portion of the back electrode layer 155 to generate the void E may mainly contain the silicon material. Hence, the generation of the void E may be minimized, and the entire resistance of the back electrode layer 155 may be further minimized. As a result, the output voltage and the fill factor may be further improved, and the photoelectric efficiency of the solar cell may be improved.

As shown in (b) of FIG. 6, the amount (or content) of the silicon material may increase in the back electrode 151 in going from the back electrode layer 155 towards the substrate 110 or the back surface field layer 170. Such an increase may be exponential, linear or in steps. On the contrary, in portions of the back electrode 151 that are farther from the substrate 110, the amount of the silicon material may decrease. For example, the amount of silicon contained in a portion of the back electrode 151 positioned closest to the substrate 110 may be about 15 wt%. Further, a portion of the back electrode 151 positioned farthest from the substrate 110 may not contain silicon at all. The depth of the back electrode 151 is d, which may be about 80 nm to about 160 nm. Accordingly, the silicon material may be more abundant in a portion of the back electrode layer 155 that is closer to the substrate 110 than in a portion of the back electrode layer 155 that is farther from the substrate 110.

The structure illustrated in (b) of FIG. 6 may reduce more efficiently the depth of the void E, compared to the case where the silicon material is uniformly distributed into the entire surface of the back electrode 151. Further, the resistance of the back electrode layer 155 may be further reduced. Hence, the photoelectric efficiency of the solar cell may be further improved.

A range of the optimum amount of silicon illustrated in FIG. 5 may be applied to the structure illustrated in FIG. 6. Alternatively, the back electrode 151 may contain more silicon than the silicon range illustrated in FIG. 5.

As described above, the solar cell according to the embodiment of the invention may prevent the void from being generated between the back electrode layer and the substrate because the back electrode layer contains the silicon material.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A solar cell comprising:
a silicon substrate (110) of a first conductive type;
an emitter layer (120) positioned at an incident surface of the substrate, the emitter layer having a second conductive type opposite the first conductive type;
a front electrode (141, 142) positioned on the incident surface of the substrate, the front electrode being electrically connected to the emitter layer;
a back passivation layer (190) positioned on a back surface opposite the incident surface of the substrate, the back passivation layer having at least one hole; and
a back electrode layer (155) positioned on the back passivation layer, the back electrode layer being electrically connected to the substrate through the at least one hole of the back passivation layer,
the back electrode layer (155) including a back electrode (151) disposed in the at least one hole,
wherein the back electrode layer (155) contains aluminum and a distribution of a silicon material,
characterized in thatan amount of the silicon material contained in the back electrode layer (155) is 6 wt% to 15 wt%, based on the total weight of the back electrode layer (155), and
the back electrode layer (155) contains the silicon material throughout its entire surface.

2. A solar cell comprising:
a silicon substrate (110) of a first conductive type;
an emitter layer (120) positioned at an incident surface of the substrate, the emitter layer having a second conductive type opposite the first conductive type;
a front electrode (141, 142) positioned on the incident surface of the substrate, the front electrode being electrically connected to the emitter layer;
a back passivation layer (190) positioned on a back surface opposite the incident surface of the substrate, the back passivation layer having at least one hole; and
a back electrode layer (155) positioned on the back passivation layer, the back electrode layer being electrically connected to the substrate through the at least one hole of the back passivation layer,
the back electrode layer (155) including a back electrode (151) disposed in the at least one hole,
wherein the back electrode layer (155) is formed of aluminum and contains a distribution of a silicon material,
**characterized in that**
only a portion of the back electrode layer (155) including the back electrode (151) contains the silicon material, and
an amount of the silicon material contained in the back electrode (151) is 6 wt% to 15 wt%, based on the total weight of the back electrode (151).

3. The solar cell of claim 2, wherein the silicon material is uniformly distributed into the entire surface of the back electrode (151).

4. The solar cell of claim 2, wherein the amount of the silicon material increases in the back electrode (151) in going from the back electrode layer (155) towards the substrate (110), and wherein the amount of the silicon material decreases in the back electrode layer (155) in going away from the substrate (110).

5. The solar cell of claim 1 or 2, further comprising a back surface field layer (170) positioned at the back surface of the substrate (110) electrically connected to the back electrode layer (155), the back surface field layer (170) being more heavily doped with impurities of the first conductive type than the substrate (110).

6. The solar cell of claim 5, wherein the back surface field layer (170) is disposed between the back electrode (151) and the substrate (110).

7. The solar cell of claim 1 or 2, further comprising an anti-reflection layer (130) positioned on the emitter layer (120), the anti-reflection layer reducing or preventing a reflection of light incident from the outside.

8. The solar cell of claim 1 or 2, wherein the silicon material is silicon beads or silicon particles.

9. A method of forming a solar cell, the method comprising:
providing a silicon substrate of a first conductive type;
forming an emitter layer positioned at an incident surface of the substrate, the emitter layer having a second conductive type opposite the first conductive type;
forming an anti-reflection layer on the emitter layer;
forming a back passivation layer on a back surface opposite the incident surface of the substrate, and providing at least one hole in the back passivation layer;
providing an Al paste containing a silicon material on a portion of the back passivation layer having the at least one hole, providing a back bus bar paste on a portion of the back passivation layer without the at least one hole, and providing a front electrode paste on the anti-reflection layer; and
firing the substrate to form a back electrode layer from the Al paste, a back bus bar from the back bus bar paste, and front electrodes from the front electrode paste,
wherein an amount of the silicon material contained in the back electrode layer is about 6 wt% to 15 wt%, based on the total weight of the back electrode layer (155).

10. The method of claim 9, wherein the silicon material is silicon beads, silicon particles, or an alloy of silicon and aluminum.

11. The method of claim 9, wherein the firing of the substrate further forms a back surface field layer between the back electrode layer and the substrate.

## Patentansprüche

1. Solarzelle, umfassend:
ein Siliziumsubstrat (110) eines ersten Leitfähigkeitstyps;
eine Emitterschicht (120), die an einer Einfallfläche des Substrats angeordnet ist, wobei die Emitterschicht einen zweiten Leitfähigkeitstyp, der zu dem ersten Leitfähigkeitstyp entgegengesetzt ist, aufweist;
eine vorderseitige Elektrode (141, 142), die auf der Einfallfläche des Substrats angeordnet ist, wobei die vorderseitige Elektrode elektrisch mit der Emitterschicht verbunden ist;
eine rückseitige Passivierungsschicht (190), die auf einer Rückseite, welche zu der Einfallfläche des Substrats entgegengesetzt ist, angeordnet ist, wobei die rückseitige Passivierungsschicht mindestens ein Loch aufweist; und
eine rückseitige Elektrodenschicht (155), die auf der rückseitigen Passivierungsschicht angeordnet ist, wobei die rückseitige Elektrodenschicht durch das mindestens eine Loch der rückseitigen Passivierungsschicht hindurch elektrisch mit dem Substrat verbunden ist,
wobei die rückseitige Elektrodenschicht (155) eine rückseitige Elektrode (151) enthält, welche in dem mindestens einen Loch angeordnet ist,
wobei die rückseitige Elektrodenschicht (155) Aluminium und eine Verteilung eines Siliziummaterials enthält,
**dadurch gekennzeichnet, dass** eine Menge des Siliziummaterials, welches in der rückseitigen Elektrodenschicht (155) enthalten ist, 6 Gew.% bis 15 Gew.%, basierend auf dem Gesamtgewicht der rückseitigen Elektrodenschicht (155), aufweist, und
wobei die rückseitige Elektrodenschicht (155) das Siliziummaterial über seine gesamte Oberfläche enthält.

2. Solarzelle, umfassend:
ein Siliziumsubstrat (110) eines ersten Leitfähigkeitstyps;
eine Emitterschicht (120), die an einer Einfallfläche des Substrats angeordnet ist,
wobei die Emitterschicht einen zweiten Leitfähigkeitstyp, der zu dem ersten Leitfähigkeitstyp entgegengesetzt ist, aufweist;
eine vorderseitige Elektrode (141, 142), die auf der Einfallfläche des Substrats angeordnet ist, wobei die vorderseitige Elektrode elektrisch mit der Emitterschicht verbunden ist;
eine rückseitige Passivierungsschicht (190), die auf einer Rückseite, welche zu der Einfallfläche des Substrats entgegengesetzt ist, angeordnet ist,
wobei die rückseitige Passivierungsschicht mindestens ein Loch aufweist; und
eine rückseitige Elektrodenschicht (155), die auf der rückseitigen Passivierungsschicht angeordnet ist, wobei die rückseitige Elektrodenschicht durch das mindestens eine Loch der rückseitigen Passivierungsschicht hindurch elektrisch mit dem Substrat verbunden ist,
wobei die rückseitige Elektrodenschicht (155) eine rückseitige Elektrode (151) enthält, welche in dem mindestens einen Loch angeordnet ist,
wobei die rückseitige Elektrodenschicht (155) aus Aluminium gebildet ist und eine Verteilung eines Siliziummaterials enthält,
**dadurch gekennzeichnet, dass** mindestens ein Teil der rückseitigen Elektrodenschicht (155), welcher die rückseitige Elektrode (151) enthält, das Siliziummaterial enthält, und wobei eine Menge des Siliziummaterials, das in der rückseitigen Elektrode (151) enthalten ist 6 Gew.% bis 15 Gew.%, basierend auf dem Gesamtgewicht der rückseitigen Elektrode (151) beträgt.

3. Solarzelle nach Anspruch 2, wobei das Siliziummaterial gleichmäßig in der gesamten Oberfläche der rückseitigen Elektrode (151) verteilt vorliegt.

4. Solarzelle nach Anspruch 2, wobei die Menge des Siliziummaterials in der rückseitigen Elektrode (151) von der rückseitigen Elektrodenschicht (151) ausgehend in Richtung zum Substrat (110) zunimmt, und wobei die Menge des Siliziummaterials in der rückseitigen Elektrodenschicht (155) in einer von dem Substrat (110) wegführenden Richtung abnimmt.

5. Solarzelle nach Anspruch 1 oder 2, des Weiteren umfassend eine rückseitige Oberflächenfeldschicht (170), die an der Rückseite des Substrats (110) angeordnet ist und elektrisch mit der rückseitigen Elektrodenschicht (155) verbunden ist, wobei die rückseitige Oberflächenfeldschicht (170) stärker mit Störstellen des ersten Leitfähigkeitstyps dotiert ist als das Substrat (110).

6. Solarzelle nach Anspruch 5, wobei die rückseitige Oberflächenfeldschicht (170) zwischen der rückseitigen Elektrode (151) und dem Substrat (110) angeordnet ist.

7. Solarzelle nach Anspruch 1 oder 2, des Weiteren umfassend eine Antireflexschicht (130), die auf der Emitterschicht (120) angeordnet ist, wobei die Antireflexschicht eine Reflektion von von außen eintreffendem Licht reduziert oder verhindert.

8. Solarzelle nach Anspruch 1 oder 2, wobei das Siliziummaterial Siliziumkügelchen oder Siliziumpartikel ist.

9. Verfahren zum Bilden einer Solarzelle, wobei das Verfahren umfasst:
Bereitstellen eines Siliziumsubstrats eines ersten Leitfähigkeitstyps;
Bilden einer Emitterschicht, die an einer Einfallsfläche des Substrats angeordnet ist, wobei die Emitterschicht einen zweiten Leitfähigkeitstyp, der zu dem ersten Leitfähigkeitstyp entgegengesetzt ist, aufweist;
Bilden einer Antireflexschicht auf der Emitterschicht;
Bilden einer rückseitigen Passivierungsschicht auf einer Rückseite, welche zu der Einfallfläche des Substrats entgegengesetzt ist, und Bereitstellen mindestens eines Lochs in der rückseitigen Passivierungsschicht;
Bereitstellen einer Al-Paste, welche ein Siliziummaterial enthält, auf einem Teil der rückseitigen Passivierungsschicht mit dem mindestens einen Loch, Bereitstellen einer rückseitigen Sammelschienenpaste auf einem Teil der rückseitigen Passivierungsschicht ohne das mindestens eine Loch, und Bereitstellen einer vorderseitigen Elektrodenpaste auf der Antireflexschicht; und
Heizen des Substrats, um eine rückseitige Elektrodenschicht aus der Al Paste, eine rückseitige Sammelschiene aus der rückseitigen Sammelschienenpaste, und vorderseitige Elektroden aus der vorderseitigen Elektrodenpaste zu bilden,
wobei eine Menge des Siliziummaterials, das in der rückseitigen Elektrodenschicht enthalten ist, etwa 6 Gew.% bis 15 Gew.% basierend auf dem Gesamtgewicht der rückseitigen Elektrodenschicht (155) beträgt.

10. Verfahren nach Anspruch 9, wobei das Siliziummaterial Siliziumkügelchen, Siliziumpartikel oder eine Legierung von Silizium und Aluminium ist.

11. Verfahren nach Anspruch 9, wobei das Erhitzen des Substrats des Weiteren eine rückseitige Oberflächenfeldschicht zwischen der rückseitigen Elektrodenschicht und dem Substrat bildet.

## Revendications

1. Cellule solaire comprenant :
un substrat de silicium (110) d'un premier type conducteur ;
une couche d'émetteur (120) positionnée au niveau d'une surface incidente du substrat, la couche d'émetteur ayant un second type conducteur opposé au premier type conducteur ;
une électrode avant (141, 142) positionnée sur la surface incidente du substrat,
l'électrode avant étant connectée électriquement à la couche d'émetteur ;
une couche de passivation arrière (190) positionnée sur une surface arrière opposée à la surface incidente du substrat, la couche de passivation arrière ayant au moins un trou ; et
une couche d'électrode arrière (155) positionnée sur la couche de passivation arrière, la couche d'électrode arrière étant connectée électriquement au substrat à travers le ou les trous de la couche de passivation arrière,
la couche d'électrode arrière (155) comprenant une électrode arrière (151) disposée dans le ou les trous,
dans laquelle la couche d'électrode arrière (155) contient de l'aluminium et une distribution d'un matériau de silicium,
**caractérisée en ce que** une quantité du matériau de silicium contenu dans la couche d'électrode arrière (155) est comprise entre 6 % en poids et 15 % en poids, par rapport au poids total de la couche d'électrode arrière (155), et
la couche d'électrode arrière (155) contient le matériau de silicium sur toute sa surface.

2. Cellule solaire comprenant :
un substrat de silicium (110) d'un premier type conducteur ;
une couche d'émetteur (120) positionnée au niveau d'une surface incidente du substrat, la couche d'émetteur ayant un second type conducteur opposé au premier type conducteur ;
une électrode avant (141, 142) positionnée sur la surface incidente du substrat, l'électrode avant étant connectée électriquement à la couche d'émetteur ;
une couche de passivation arrière (190) positionnée sur une surface arrière opposée à la surface incidente du substrat, la couche de passivation arrière ayant au moins un trou ; et
une couche d'électrode arrière (155) positionnée sur la couche de passivation arrière, la couche d'électrode arrière étant connectée électriquement au substrat à travers le ou les trous de la couche de passivation arrière,
la couche d'électrode arrière (155) comprenant une électrode arrière (151) disposée dans le ou les trous,
dans laquelle la couche d'électrode arrière (155) est formée d'aluminium et contient une distribution d'un matériau de silicium,
**caractérisée en ce que**
seule une partie de la couche d'électrode arrière (155) comprenant l'électrode arrière (151) contient le matériau de silicium, et
une quantité du matériau de silicium contenu dans l'électrode arrière (151) est comprise entre 6 % en poids et 15 % en poids, par rapport au poids total de l'électrode arrière (151).

3. Cellule solaire selon la revendication 2, dans laquelle le matériau de silicium est uniformément réparti dans toute la surface de l'électrode arrière (151).

4. Cellule solaire selon la revendication 2, dans laquelle la quantité de matériau de silicium augmente dans l'électrode arrière (151) en allant de la couche d'électrode arrière (155) vers le substrat (110), et dans laquelle la quantité de silicium diminue dans la couche d'électrode arrière (155) en s'éloignant du substrat (110).

5. Cellule solaire selon la revendication 1 ou 2, comprenant en outre une couche de champ de surface arrière (170) positionnée au niveau de la surface arrière du substrat (110) connectée électriquement à la couche d'électrode arrière (155), la couche de champ de surface arrière (170) étant plus fortement dopée avec des impuretés du premier type conducteur que le substrat (110).

6. Cellule solaire selon la revendication 5, dans laquelle la couche de champ de surface arrière (170) est disposée entre l'électrode arrière (151) et le substrat (110).

7. Cellule solaire selon la revendication 1 ou 2, comprenant en outre une couche anti-reflet (130) positionnée sur la couche d'émetteur (120), la couche anti-reflet réduisant ou empêchant une réflexion de la lumière incidente provenant de l'extérieur.

8. Cellule solaire selon la revendication 1 ou 2, dans laquelle le matériau de silicium est constitué de billes de silicium ou de particules de silicium.

9. Procédé de formation d'une cellule solaire, le procédé comprenant :
la fourniture d'un substrat de silicium d'un premier type conducteur ;
la formation d'une couche d'émetteur positionnée au niveau d'une surface incidente du substrat, la couche d'émetteur ayant un second type conducteur opposé au premier type conducteur ;
la formation d'une couche anti-reflet sur la couche d'émetteur ;
la formation d'une couche de passivation arrière sur une surface arrière opposée à la surface incidente du substrat, et la fourniture d'au moins un trou dans la couche de passivation arrière ;
la fourniture d'une pâte d'Al contenant un matériau de silicium sur une partie de la couche de passivation arrière ayant le ou les trous, la fourniture d'une pâte de barre de bus arrière sur une partie de la couche de passivation arrière dépourvue du ou des trous, et la fourniture d'une pâte d'électrode avant sur la couche anti-reflet ; et
la cuisson du substrat pour former une couche d'électrode arrière à partir de la pâte Al, une barre de bus arrière à partir de la pâte de barre de bus arrière, et des électrodes avant à partir de la pâte d'électrode avant,
dans laquelle une quantité de matériau de silicium contenu dans la couche d'électrode arrière est d'environ 6 % en poids à 15 % en poids, par rapport au poids total de la couche d'électrode arrière (155).

10. Procédé selon la revendication 9, dans lequel le matériau de silicium est constitué de billes de silicium, de particules de silicium ou d'un alliage de silicium et d'aluminium.

11. Procédé selon la revendication 9, dans lequel la cuisson du substrat forme en outre une couche de champ de surface arrière entre la couche d'électrode arrière et le substrat.
